# EUROPEAN PATENT SPECIFICATION

(11) **EP 4 161 039 B1**
(45) Date of publication and mention of the grant of the patent: **09.10.2024**
(21) Application number: 21855210.7
(22) Date of filing: 10.06.2021
(51) Int. Cl.: H04M 1/02, F16C 11/04, G06F 1/16, G09F 9/30

(54) **ROTATING SHAFT MODULE, FOLDING ASSEMBLY, AND ELECTRONIC APPARATUS**
DREHWELLENMODUL, FALTANORDNUNG UND ELEKTRONISCHE VORRICHTUNG
MODULE D'ARBRE ROTATIF, ENSEMBLE DE PLIAGE ET APPAREIL ÉLECTRONIQUE

(30) Priority: 10.08.2020 CN 202010797452
(43) Date of publication of application: 05.04.2023
(60) Divisional application: 24195150.8
(73) Proprietor: GUANGDONG OPPO MOBILE TELECOMMUNICATIONS CORP., LTD., Dongguan, Guangdong 523860 (CN)
(72) Inventor: XI, Qiang, Dongguan, Guangdong 523860 (CN)
(74) Representative: Ipside
(86) International application number: PCT/CN2021/099436
(87) International publication number: WO 2022/033154

(56) References cited:
- CN-A- 110 769 109
- CN-A- 112 019 664
- CN-U- 206 539 598
- CN-U- 209 691 263
- CN-Y- 2 699 630
- US-A1- 2005 236 869

## Description

### TECHNICAL FIELD

The present disclosure relates to the field of smart devices, and in particular to a rotating shaft module, a folding assembly, and an electronic apparatus.

### BACKGROUND

A common synchronous transmission mechanism in a screen-foldable cell phone is configured to achieved the transmission by means of gears, and much space may be occupied due to designing a large number of the gears, causing a whole size, in particular to a size in a thickness direction, of the synchronous transmission mechanism in the screen-foldable cell phone to be larger. However, no solution is designed in the related art to replace the synchronous transmission by means of gears.

US20050236869A1 discloses a portable apparatus. The portable apparatus comprises a first unit, a second unit, and a hinge device that is coupled to the first and second units such that the units can be moved to be in contact with or spaced apart from each other and allows relative sliding movement between the first and second units within a certain range. The hinge device exerts a force in a direction in which the first and second units are spaced apart from each other, through the relative sliding movement by a predetermined distance between the two units in the complete contact state of the first and second units.

CN206539598U provides a synchronous rotating mechanism, a reversible tablet computer and a reversible mobile phone, and relates to the technical field of equipment and electronic products. The synchronous rotating mechanism includes a first rotating shaft, a second rotating shaft, a movable block and a sleeve, the first rotating shaft and the second rotating shaft pass through the sleeve, and the side walls of the two rotating shafts are respectively provided with a first spiral groove and a second spiral groove with opposite directions. The left and right sides of the movable block are respectively placed in the two grooves. When the first rotating shaft and the second rotating shaft rotate, the movable block can move axially along the sleeve, so as to realize synchronous rotations of the two rotating shafts. The synchronous rotating mechanism may be used to make a reversible tablet computer and a reversible mobile phone, which increases the flexibility and convenience of using the computer and mobile phone and solves the problem that the synchronous rotating of the computer or mobile phone in the prior art is limited by the axis of the product, or the thickness limit, or the problem of synchronous rotations when the axis and thickness requirements are met.

CN110769109A relates to a foldable mobile terminal. The foldable mobile terminal comprises a shell assembly, a folding mechanism and a flexible display screen, the shell assembly comprises a first shell and a second shell. The folding mechanism comprises a folding assembly and a clamping assembly, the folding assembly comprises a first rotating rod and a second rotating rod, the clamping assembly comprises a first shaft sleeve, a fifth elastic piece and a clamping piece, a plurality of first clamping grooves are formed in the clamping piece in the circumferential direction of the first rotating rod, first protrusions are arranged on the first shaft sleeve, and the first protrusions can be clamped in the first clamping grooves; when the first rotating rod rotates, the first protrusion can enter the other first clamping groove from one first clamping groove. The flexible display screen covers the first shell and the second shell; and when the foldable mobile terminal is folded, the flexible display screen is hidden between the first shell and the second shell. According to the foldable mobile terminal, hand feeling feedback can be achieved for a user through stagnation in the folding and unfolding processes.

### SUMMARY OF THE DISCLOSURE

The present disclosure is set out in the appended set of claims.

In the above solutions, the first connecting member is configured to be threaded to each rotating shaft. When one rotating shaft rotates, the first connecting member may move along an axial direction due to a thread cooperating relationship, and two rotating shafts may keep the same axial movement due to a thread cooperating relationship between another rotating shaft and the first connecting member. Under a cooperation of the elastic assembly, each rotating shaft may keep stable.

### BRIEF DESCRIPTION OF THE DRAWINGS

FIG. 1 is a structural schematic view of an electronic apparatus according to an embodiment of the present disclosure.
FIG. 2 is an exploded view of the electronic apparatus according to an embodiment of the present disclosure.
FIG. 3 is an exploded view of a part of a structure of the electronic apparatus according to an embodiment of the present disclosure.
FIG. 4 is a structural schematic view of a housing according to an embodiment of the present disclosure.
FIG. 5 is a structural schematic view of a connecting member according to an embodiment of the present disclosure.
FIG. 6 is a structural schematic view of the connecting member according to an embodiment of the present disclosure.
FIG. 7 is a structural schematic view of a folding assembly according to an embodiment of the present disclosure.
FIG. 8 is a structural schematic view of a pallet from a perspective according to an embodiment of the present disclosure.
FIG. 9 is a structural schematic view of the pallet from another perspective according to an embodiment of the present disclosure.
FIG. 10 is a structural schematic view of a supporting bracket according to an embodiment of the present disclosure.
FIG. 11 is a structural schematic view of a rotating shaft module according to an embodiment of the present disclosure.
FIG. 12 is an exploded view of the rotating shaft module according to an embodiment of the present disclosure.
FIG. 13 is an exploded view of a mounting housing according to an embodiment of the present disclosure.
FIG. 14 is a structural schematic view of the rotating shaft assembly according to an embodiment of the present disclosure.
FIG. 15 is a structural schematic view of a part of a structure of the rotating shaft assembly according to an embodiment of the present disclosure.
FIG. 16 is a cross-section schematic view of a part of the structure of the rotating shaft assembly according to an embodiment of the present disclosure.
FIG. 17 is a structural schematic view of the electronic apparatus according to another embodiment of the present disclosure.
FIG. 18 is a structural schematic view of the electronic apparatus according to an embodiment of the present disclosure.

### DETAILED DESCRIPTION

The present disclosure is further described in detail below in conjunction with the accompanying drawings and embodiments. In particular, it is noted that the following embodiments are configured only to illustrate the present disclosure, but do not limit the scope of the present disclosure. Similarly, the following embodiments are only some but not all embodiments of the present disclosure, and all other embodiments obtained by a person of ordinary skill in the art without creative labor fall within the scope of the present disclosure.

"Embodiment" herein means that a particular feature, structure, or characteristic described with reference to embodiments may be included in at least one embodiment of the present disclosure. The terms appearing in various places in the specification are not necessarily as shown in the same embodiment, and are not exclusive or alternative embodiments that are mutually exclusive with other embodiments. Those skilled in the art will understand explicitly and implicitly that the embodiments described herein may be combined with other embodiments.

"Electronic apparatus" herein (which may also be referred to as a "terminal", a "mobile terminal", or an "electronic device") includes, but is not limited to an apparatus which is configured to be connected by a wire line (e.g., via a public switched telephone network (PSTN), a digital subscriber line (DSL), a digital cable, a direct cable connection, and/or another data connection/network) and/or receive/transmit a communication signal via a wireless interface (e.g., the wireless interface for a cellular network, a wireless local area network (WLAN), a digital television network such as a DVB-H network, a satellite network, an AM-FM broadcast transmitter, and/or of another communication terminal). A communication terminal configured to communicate via the wireless interface may be referred to as a "wireless communication terminal", a "wireless terminal", or a "mobile terminal". Examples of the mobile terminal may include, but are not limited to, a satellite or cellular telephone: a personal communication system (PCS) terminal which may combine a cellular radio telephony with capabilities including data processing, faxing, and data communication; a personal digital assistant (PDA) which may include a radio telephone, a pager, an Internet/Intranet access, a Web browser, a notepad, a calendar, and/or a global positioning system (GPS) receiver; and a conventional laptop and/or handheld receiver or other electronic apparatus including a radiotelephone transceiver. A cell phone is an electronic device equipped with a cellular communication module.

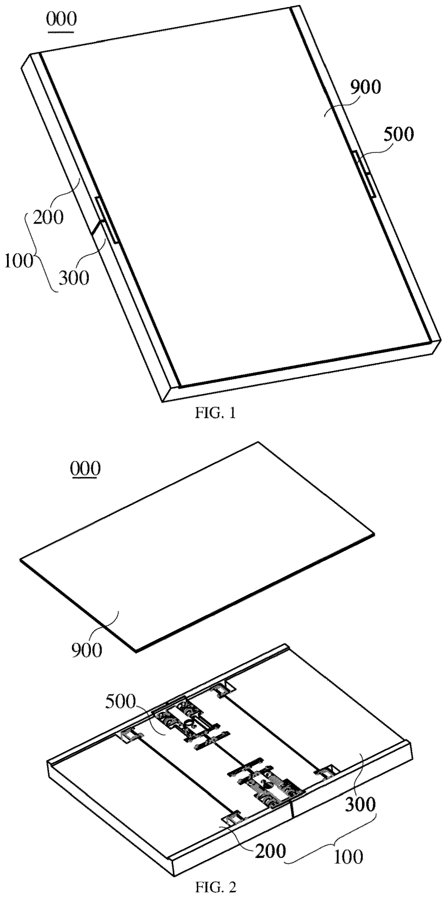

As shown in FIG. 1, FIG. 1 is a structural schematic view of an electronic apparatus according to an embodiment of the present disclosure. The electronic apparatus 000 may be any one of a plurality of electronic devices. The plurality of electronic devices include but are not limited to, cellular telephones, smart phones, other wireless communication devices, personal digital assistants, audio players, other media players, music recorders, video recorders, cameras, other media recorders, radios, medical devices, calculators, programmable remote controls, pagers, netbook computers, Personal Digital Assistants (PDAs), Portable Multimedia Players (PMPs), Motion Picture Expert Groups (MPEGs-1 or MPEGs-2), Audio Layer 3 (MP3) players, portable medical devices, and digital cameras, and combinations of these devices.

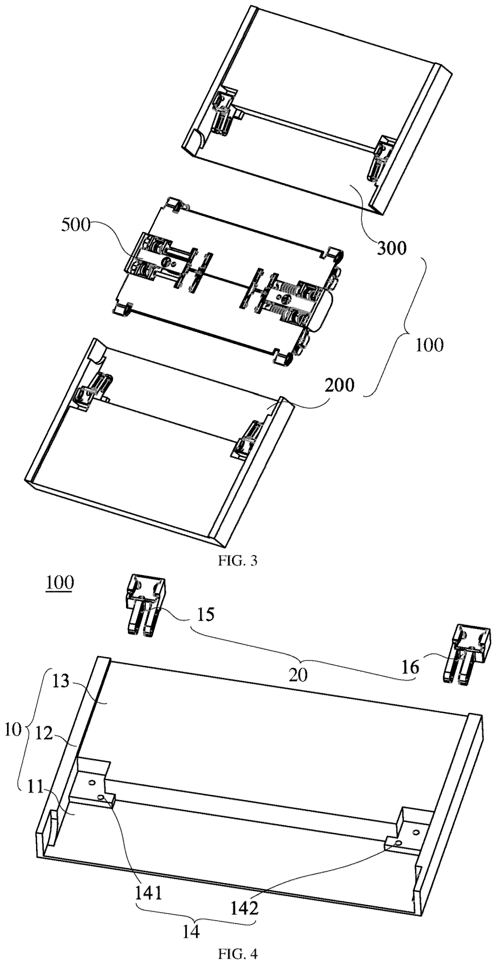

As shown in FIGS. 1, 2, and 3, FIG. 2 is an exploded view of the electronic apparatus 000 according to an embodiment of the present disclosure, and FIG. 3 is an exploded view of a part of a structure of the electronic apparatus 000 according to an embodiment of the present disclosure. The electronic apparatus 000 includes a housing 100 (e.g., a first housing 200, a second housing 300, etc.), a folding assembly 500, and a display module 900. The number of the housings 100 may be two or more. The housing 100 is configured to carry the display module 900, or configured to carry an electronic component such as a circuit board, a battery, a camera, etc. For example, the housing 100 in FIG. 1 includes the first housing 200 and the second housing 300. Two adjacent housings 100 in the multiple housings 100 are fixedly connected to each other through the folding assembly 500, so as to allow the multiple housings 100 to be foldable and further enable the electronic apparatus 000 to be foldable. For example, in FIG. 1, the first housing 200 and the second housing 300 are fixedly connected to each other through the folding assembly 500 to allow the first housing 200 and the second housing 300 to be folded towards each other. The display module 900 is configured to display information and electrically connected to the electronic component such as the circuit board, the battery, etc. The display module 900 is mounted on the multiple housings 100. The display module 900 may be folded when the multiple housings 100 are folded, so as to achieve folding the electronic apparatus 000, facilitating a storage of the electronic apparatus 000. The electronic apparatus 000 may be used when the multiple housings 100 are unfolded. For example, the display module 900 in FIG. 1 is located on same sides of the first housing 200 and the second housing 300, and mounted on both the first housing 200 and the second housing 300. The display module 900 may be folded in half with the first housing 200 and the second housing 300 being folded towards each other.

In addition, terms such as "first", "second", and the like, are used herein and hereafter for purposes of description, and are not intended to indicate or imply relative importance or significance or to imply the number of indicated technical features. Thus, the feature defined with "first", "second", and the like may include one or more of such a feature.

It can be understood that names such as "first housing", "second housing", "casing", "housing", etc., are interchangeable. For example, the name "first housing" may also be referred to as "second housing".

Specifically, as shown in FIG. 3 and FIG. 4, FIG. 4 is a structural schematic view of a housing 100 according to an embodiment of the present disclosure. The number of the housings 100 is two, for example, the housings 100 include the first housing 200 and the second housing 300. Each of the housings 100 includes a housing body 10 and a connecting member 20. The housing body 10 is configured to carry the display module 900 and may also be configured to be arranged with the electronic component such as the circuit board, the battery, etc. The connecting member 20 is mounted on the housing body 10 and is configured to be connected to the folding assembly 500 to achieve a connection between the housing 100 and the folding assembly 500.

Specifically, as shown in FIG. 4, the housing body 10 may include a base plate 11, a side wall 12, and a substrate 13. The side wall 12 may be arranged on an edge of the base plate 11, i.e., the side wall 12 may surround, enclose, or be disposed around the edge of the base plate 11, such that the base plate 11 and the side wall 12 may define an accommodation space configured to accommodate the electronic component such as the camera, the circuit board, the battery, the display module 900, etc. The substrate 13 is arranged opposite to the base plate 11 and fixedly connected to the side wall 12. That is, the side wall 12 surrounds or is disposed around a periphery of the substrate 13 and is fixed to the substrate 13 to form a middle frame. The accommodation space may be divided into two parts by the substrate 13 to form a first accommodation space and a second accommodation space. The first accommodation space is located between the base plate 11 and the substrate 13 and configured to receive the electronic component such as the camera, the circuit board, the battery, etc. The second accommodation space is located on a side of the substrate 13 away from the base plate 11 and configured to receive the display module 900.

As shown in FIG. 4, the base plate 11 may have a plate-shaped structure. The base plate 11 may be substantially in a rectangular shape or a rounded rectangular shape, etc. A material of the base plate 11 may be a plastic, a glass, a ceramic, a fiber composite, a metal (e.g., a stainless steel, an aluminum, etc.), or other suitable materials or a combination of these materials. In some embodiments, the material of a part of the base plate 11 may be dielectric or other low-conductivity material. In other embodiments, the base plate 11 may be a metal element, or at least some structures of the base plate 11 may be metal elements.

The base plate 11 is provided with a mounting portion 14 configured to mount the connecting member 20. The number of the mounting portions 14 may be multiple. For example, in FIG. 4, the number of the mounting portions 14 is two, and the two mounting portions 14 include a first mounting portion 141 and a second mounting portion 142. Both the first mounting portion 141 and the second mounting portion 142 are provided on an edge of the base plate 11. The first mounting portion 141 is arranged close to the side wall 12 on a side of the base plate 11, and the second mounting portion 142 is arranged close to the side wall 12 on an opposite side of base plate 11.

The mounting portion 14 is a hole inwardly recessed from the base plate 11, and configured to be inserted by the connecting member 20 to fix the connecting member 20. The connecting member 20 may also be fixed to the mounting portion 14 by means of glue.

The side wall 12 is disposed or enclosed around the edge of the base plate 11 and extends towards a same side of the base plate 11. The side wall 12 is cut or opened on a side of the base plate 11 where the mounting portion 14 is arranged and an opening is defined on the side of the base plate 11 where the mounting portion 14 is arranged, so as to provide an avoiding room or clearance for the folding assembly 500. That is, side walls 12 are disposed around three edges of the base plate 11, and a remaining edge of the base plate 11 is arranged without the side wall 12 to define the opening. The mounting portion 14 is disposed adjacent to the remaining edge of the base plate 11.

The side wall 12 has a less wall thickness at a position defining the opening than wall thicknesses at other positions, so as to provide the room for the folding assembly 500. Understandably, the number of the openings may be more than one, and may be two or three. For example, the sidewalls 12 in FIG. 4 may also be disposed on and surround two opposite edges of the base plate 11, and each of the other two edges of the base plate 11 defines an opening. Of course, in some embodiments, the sidewalls 12 may also be disposed on two adjacent edges of the base plate 11, and each of the other two edges of the base plate 11 defines the opening.

In an embodiment, the base plate 11 and the side walls 12 are of an integrated structure, and the side wall 12 includes the same material with the base plate 11.

In an embodiment, as shown in FIG. 4, the side wall 12 and the substrate 13 are of an integrated structure, and the substrate 13 may be made of the same material as the side wall 12. In an embodiment, the substrate 13 does not cover the base plate 11 at the opening to provide the room for the folding assembly 500, such that a part of a structure of the folding assembly 500 is arranged on the base plate 11.

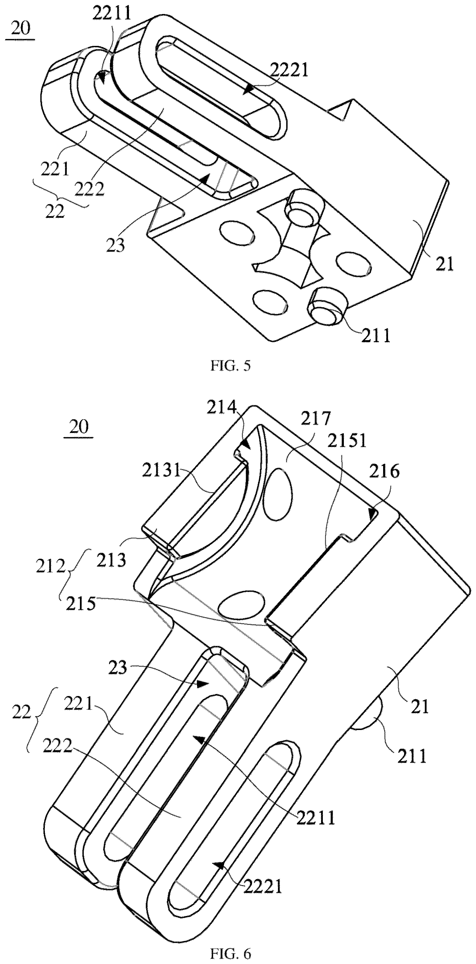

As shown in FIGS. 4, 5 and 6, FIG. 5 is a structural schematic view of a connecting member 20 according to an embodiment of the present disclosure. FIG. 6 is a structural schematic view of the connecting member 20 according to an embodiment of the present disclosure. The connecting member 20 is configured to be connected to the folding assembly 500. The number of the connecting members 20 may be multiple. For example, the number of the connecting members 20 may be two, and the two connecting members 20 include a first connecting member 15 and a second connecting member 16. The first connecting member 15 is mounted on the mounting portion 14, such as the first mounting portion 141. The second connecting member 16 is mounted on the mounting portion 14, such as the second mounting portion 142.

Specifically, the connecting member 20 may include a connecting member body 21 and a buffer arm 22. The connecting member body 21 is mounted on the mounting portion 14, such as the first mounting portion 141 or the second mounting portion 142. The buffer arm 22 is arranged at an opening of the connecting member body 21 and extends towards an outer side of the opening. The buffer arm 22 is connected to the folding assembly 500 in a slide manner.

As shown in FIG. 5, an insertion post 211 is arranged on a side of the connecting member body 21 facing towards the base plate 11, extendedly, so as to be inserted into and connected to the mounting portion 14 on the base plate 11, such as the first mounting portion 141 or the second mounting portion 142. Understandably, the connecting member body 21 may also be fixedly connected to the mounting portion 14, such as the first mounting portion 141 or the second mounting portion 142, by means of gluing, bolting, etc. Of course, the connecting member body 21 and the base plate 11 may be of an integrated structure.

As shown in FIG. 6, connection walls 212, such as a first connection wall 213 and a second connection wall 215, are arranged on a side of the connecting member body 21 away from the base plate 11. Each of the connection walls 212 extends and is disposed on a corresponding one of both sides substantially parallel to a direction from the connecting member body 21 to the buffer arm 22. A limiting column 2131 is arranged on a side of the first connection wall 213 facing towards the second connection wall 215, protrudes from the first connection wall 213, and extends towards the second connection wall 215. A limiting column 2151 is arranged on a side of the second connection wall 215 facing towards the first connection wall 213, protrudes from the second connection wall 215, and extends towards the first connection wall 213. The limiting column 2131 and the limiting column 2151 are arranged opposite to each other. A gap between the limiting column 2131 and the connecting member body 21 and a gap between the limiting column 2151 and the connecting member body 21 define a track (such as a first track 214 and a second track 216), respectively. In this way, it is easier for the limiting column 2131 and the limiting column 2151 to be snapped or engaged with the folding assembly 500. Apart of a structure of the folding assembly 500 may slide on the tracks, such that the folding assembly 500 may rotate around the limiting column 2131 and the limiting column 2151. In an embodiment, the first connection wall 213 or the second connection wall 215 may be omitted.

In an embodiment, a surface of the connecting member body 21 on a side away from the base plate 11 is recessed inwardly and defines a recess 217 to provide the room for the folding assembly 500. The recess 217 is located between the limiting post 2131 and the limiting post 2151. In order to facilitate a rotation of the folding assembly 500, the track may be in a circular arc shape, which also facilitates the folding assembly 500 to rotate out of the track to achieve disassembly of the folding assembly 500 and the connecting member 20, and also facilitates the folding assembly 500 to rotate into the track to achieve assembly of the folding assembly 500 and the connecting member 20 and subsequent use of the electronic apparatus 000 when folded.

As shown in FIGS. 5 and 6, the number of the buffer arms 22 may be one or more. For example, the number of buffer arms 22 is two, and the two buffer arms 22 include a first buffer arm 221 and a second buffer arm 222. A gap is defined between two adjacent buffer arms 22 to provide the room for the folding assembly 500. For example, a gap 23 is defined between the first buffer arm 221 and the second buffer arm 222. Each buffer arm 22 defines a strip through hole, and the strip through hole defined in one buffer arm 22 is arranged opposite to the strip through hole defined in the other buffer arm 22, such that a part of the structure of the folding assembly 500 may pass through each strip through hole together and slide in a length direction of each strip through hole. For example, the first buffer arm 221 defines a first strip through hole 2211, and the second buffer arm 222 defines a second strip through hole 2221.

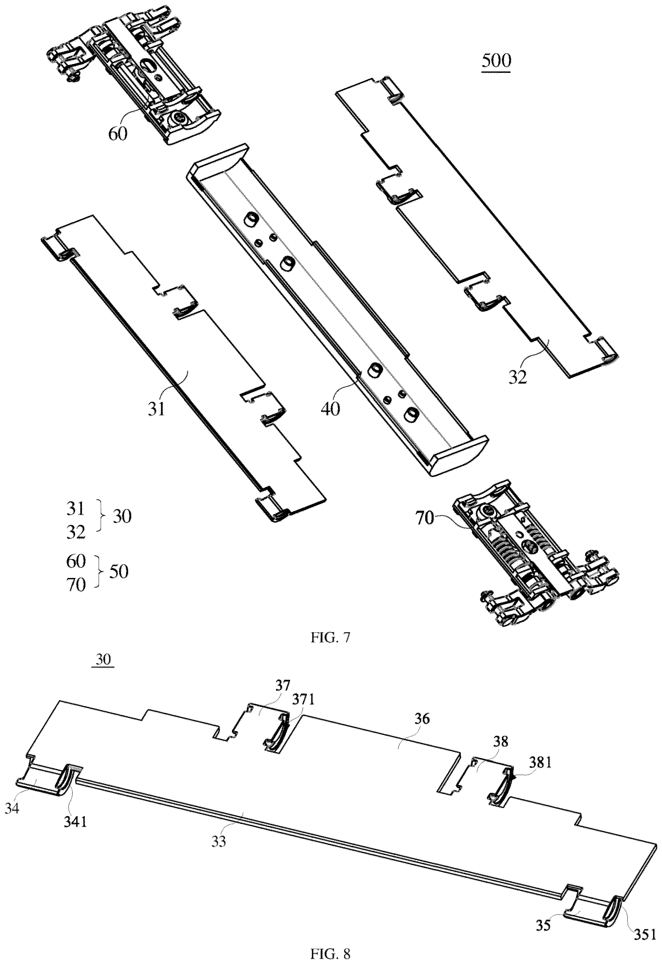

As shown in FIG. 7, FIG. 7 is a structural schematic view of a folding assembly 500 according to an embodiment of the present disclosure. The folding assembly 500 may include pallets 30 (e.g., a first pallet 31, and a second pallet 32), a supporting bracket 40, and a rotating shaft module 50 (e.g., a first rotating shaft module 60, and a second rotating shaft module 70). Specifically, the supporting bracket 40 is arranged between two adjacent housings 100. For example, the supporting bracket 40 is arranged between the first housing 200 and the second housing 300. The first rotating shaft module 60 and the second rotating shaft module 70 of the rotating shaft module 50 are located at both ends of the supporting bracket 40, respectively. That is, the first rotating shaft module 60 is located at one end of the supporting bracket 40, and the second rotating shaft module 70 is located at the other end of the supporting bracket 40. The first rotating shaft module 60 and the second rotating shaft module 70 are fixedly connected to the supporting bracket 40. The rotating shaft module 50 is arranged between two adjacent housings 100 and connected to the two adjacent housings 100, such that the two adjacent housings 100 may be folded when the rotating shaft module 50 is rotated. For example, both the first rotating shaft module 60 and the second rotating shaft module 70 may allow the first housing 200 and the second housing 300 to be connected together. The first pallet 31 and the second pallet 32 of the pallets 30 are arranged substantially symmetrically on two opposite sides of the supporting bracket 40, respectively. That is, the first pallet 31 is arranged on a first side of the supporting bracket 40, and the second pallet 32 is arranged on a second side opposite to the first side of the supporting bracket 40. The first pallet 31 is located between the first rotating shaft module 60 and the second rotating shaft module 70 and is rotatably connected to the first housing 200. The first pallet 31 is also rotatably connected to the first rotating shaft module 60 and the second rotating shaft module 70, respectively. The second pallet 32 is located between the first shaft module 60 and the second shaft module 70 and is rotatably connected to the second housing 300. The second pallet 32 is also rotatably connected to the first rotating shaft module 60 and the second rotating shaft module 70, respectively. The first pallet 31 and the second pallet 32 may be carried on the supporting bracket 40 and configured to carry the display module 900. The first pallet 31, the second pallet 32, and the display module 900 are fixed together for protecting the display module 900 and reducing a possibility of the display module 900 being bent and damaged when the folding assembly 500 is folded.

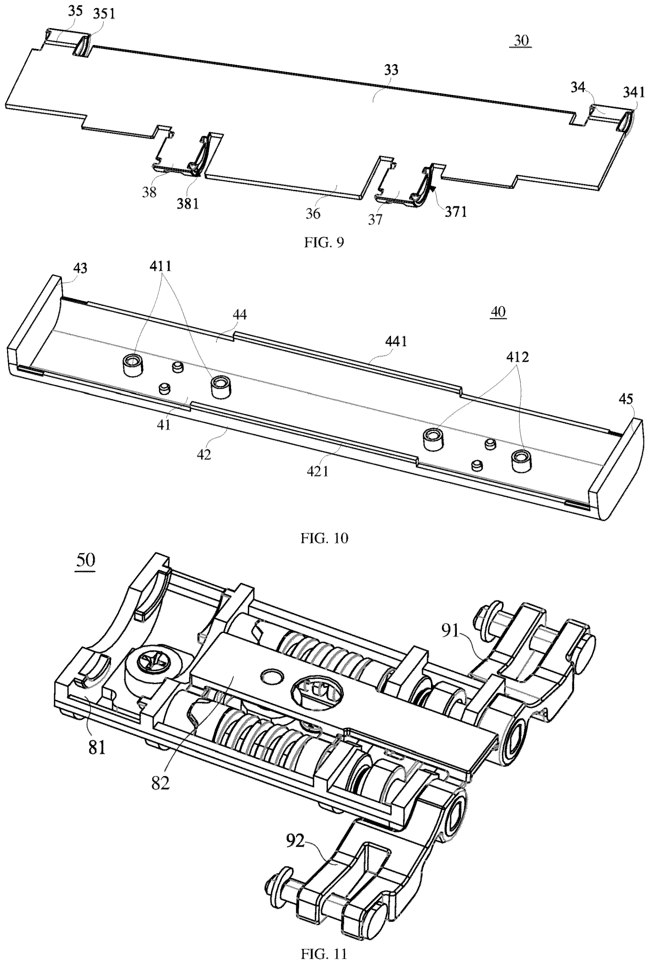

As shown in FIGS. 7, 8, and 9, FIG. 8 is a structural schematic view of a pallet 30 from a perspective according to an embodiment of the present disclosure. FIG. 9 is a structural schematic view of the pallet 30 from another perspective according to an embodiment of the present disclosure. The number of the pallets 30 may be multiple. For example, the pallets 30 may include two pallets, i.e., the first pallet 31 and the second pallet 32. The first pallet 31 and the second pallet 32 are arranged substantially symmetrically on two sides of the supporting bracket 40, respectively. That is, the first pallet 31 is arranged on the first side of the supporting bracket 40, and the second pallet 32 is arranged on the second side opposite to the first side of the supporting bracket 40. The first pallet 31 and the second pallet 32 are configured to be bonded or attached to the display module 900 and carry the display module 900 during folding or unfolding of the housing assembly 100, such that the display module 900 may be bent and folded and a surface of the display module 900 tends to be flat when the display module 900 is unfolded.

Specifically, the pallet 30 may include a connection plate 33. The connection plate 33 may be a strip-shaped plate structure and configured to be bonded or attached to the display module 900. Each of two ends of a side edge of the connection plate 33 is provided with a connection portion, such as a first connection portion 34 or a second connection portion 35, and the connection portion is configured to be rotatably connected to the connecting member 20. The first connection portion 34 has a shape adapted to the recess 217 on the second connecting member 16, such that the first connection portion 34 is received in the recess 217. Sliders 341 respectively corresponding to the first rack 214 and the second rack 216 of the second connecting member 16 are arranged on and protrude from the first connection portion 34. The sliders 341 are located at two sides of the first connection portion 34, respectively, so as to facilitate the sliders 341 sliding in the track and achieve the pallet 30 rotating relative to the connecting member 20. The second connection portion 35 has a shape adapted to the recess 217 on the first connecting member 15, such that the second connection portion 35 is received in the recess 217. Sliders 351 respectively corresponding to the first rack 214 and the second rack 216 of the first connecting member 15 are arranged on and protrude from the second connection portion 35. The sliders 351 are located at two sides of the second connection portion 35, respectively, so as to facilitate the sliders 351 sliding in the track and achieve the pallet 30 rotating relative to the connecting member 20.

An avoidance plate 36 is arranged on another side of the connection plate 33 away from the first connection portion 34 and the second connection portion 35, and the avoidance plate 36 protrudes and extends away from the first connection portion 34 and the second connection portion 35. In this way, when the folding assembly 500 is folded, the avoidance plate 36 is arranged in the supporting bracket 40, so as to provide the room for the display module 900.

A connection portion, such as a third connection portion 37 or a fourth connection portion 38, is arranged on each of both sides of the avoidance plate 36. For example, the third connection portion 37 is arranged on a left side of the avoidance plate 36, and the fourth connection portion 38 arranged on a right side of the avoidance plate 36. The connection portion is configured to be connected to the corresponding rotating shaft module 50. For example, the third connection portion 37 is configured to be rotatably connected to the first rotating shaft module 60. For example, the fourth connection 38 is configured to be rotatably connected to the second shaft module 70. The third connection portion 37 is provided with an arc slide 371 configured to be rotatably connected to the first rotating shaft module 60. The fourth connection portion 38 is provided with an arc slide 381 configured to be rotatably connected to the second rotating shaft module 70. The arc slide 371 and the arc slide 381 are configured to facilitate assembly and disassembly of the rotating shaft module 50 and the pallets 30.

As shown in FIG. 7 and FIG. 10, FIG. 10 is a structural schematic view of a supporting bracket 40 according to an embodiment of the present disclosure. The supporting bracket 40 may include a support plate 41 and sidewall plates (e.g., a first sidewall plate 42, a second sidewall plate 43, a third sidewall plate 44, and a fourth sidewall plate 45). The sidewall plates, such as the first sidewall plate 42, the second sidewall plate 43, the third sidewall plate 44, and the fourth sidewall plate 45, are connected in sequence in an end-to-end manner and enclose around the support plate 41 to define a receiving space, and the receiving space is configured to accommodate the rotating shaft module 50.

The support plate 41 has a strip-shaped structure. A part of the support plate 41 may be arranged in the accommodation space of the first housing 200 through the opening of the first housing 200, and another part of the support plate 41 may be arranged in the accommodation space of the second housing 300 through the opening of the second housing 300. A first fixing portion 411 is arranged on one end of the support plate 41 and configured to mount and fix the first rotating shaft module 60, and a second fixing portion 412 is arranged on the other end of the support plate 41 and configured to mount and fix the second rotating shaft module 70.

The first sidewall plate 42 and the third sidewall plate 44 are arranged opposite to each other and configured to support the pallets 30. A protruding portion 421 is arranged on a middle portion of the first sidewall plate 42, protrudes and extends away from the support plate 41, and is configured to support the avoidance plate 36 of the first pallet 31. A protruding portion 441 is arranged on a middle portion of the third sidewall plate 44, protrudes and extends away from the support plate 41, and is configured to support the avoidance plate 36 of the second pallet 32. The second sidewall plate 43 and the fourth sidewall plate 45 are arranged opposite to each other, and extend away from the support plate 41, respectively. Heights of the second sidewall plate 43 and the fourth sidewall plate 45 extending away from the support plate 41 are greater than heights of the first sidewall plate 42 and the third sidewall plate 44 protruding from the support plate 41. In this way, the second sidewall plate 43 and the fourth sidewall plate 45 may shield the rotating shaft module 50, reducing a possibility of affecting an overall appearance of the electronic apparatus 000 since the rotating shaft module 50 is exposed from a side surface.

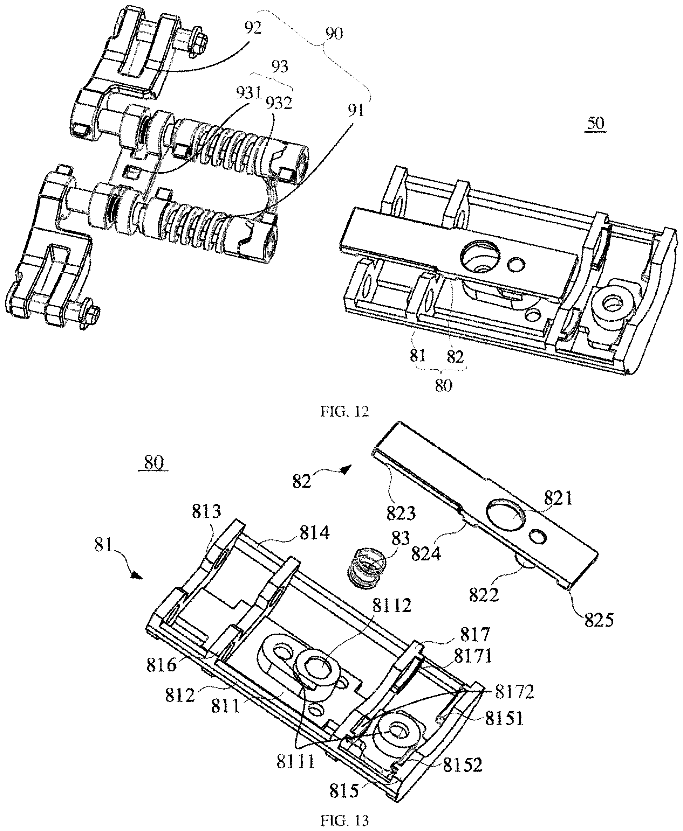

As shown in FIG. 7, FIG. 11 and FIG. 12, FIG. 11 is a structural schematic view of the rotating shaft module 50 according to an embodiment of the present disclosure, and FIG. 12 is an exploded view of the rotating shaft module 50 according to an embodiment of the present disclosure. In the folding assembly 500, the number of the rotating shaft modules 50 may be two. For example, the two rotating shaft modules 50 include the first rotating shaft module 60 and the second rotating shaft module 70. The first rotating shaft module 60 and the second rotating shaft module 70 are located in the receiving space and are arranged symmetrically at both ends of the supporting bracket 40, respectively. That is, the first rotating shaft module 60 is arranged on one end of the supporting bracket 40, and the second rotating shaft module 70 is arranged on the other end of the supporting bracket 40. Each of the rotating shaft modules 50 includes a mounting housing 80 and a rotating shaft assembly 90. Specifically, the mounting housing 80 is configured to be mounted on the supporting bracket 40 to carry the rotating shaft assembly 90 and the display module 900. The rotating shaft assembly 90 is mounted on the mounting housing 80 and configured to be rotatably connected to the connecting member 20 of the first housing 200 and rotatably connected to the connecting member 20 of the second housing 300.

As shown in FIGS. 11, 12 and 13, FIG. 13 is an exploded view of the mounting housing 80 according to an embodiment of the present disclosure. The mounting housing 80 includes a housing body 81, a supporting member 82, and a resilient member 83. The supporting member is substantially in shape of a plate. Specifically, the housing body 81 is fixed to the supporting bracket 40 and is configured to be mounted with the rotating shaft assembly 90. The supporting member 82 is mounted on the housing body 81 and carried on the rotating shaft assembly 90, and configured to carry the display module 900. When the rotating shaft assembly 90 rotates, the supporting member 82 moves to a side close to the housing body 81 so as to provide the room for the display module 900, or the supporting member 82 moves away from the housing body 81 so as to flatten the display module 900. The resilient member 83 is arranged between the housing body 81 and the supporting member 82, and configured to support the supporting member 82 and buffer a relative motion between the housing body 81 and the supporting member 82. The housing body 81 may include a mounting plate 811, enclosure plates or surrounding plates (e.g., a first surrounding plate 812, a second surrounding plate 813, a third surrounding plate 814, and a fourth surrounding plate 815), and separating plates (e.g., a first separating plate 816 and a second separating plate 817). A plurality of surrounding plates, such as the first surrounding plate 812, the second surrounding plate 813, the third surrounding plate 814, and the fourth surrounding plate 815, are connected in sequence in an end-to-end manner. The plurality of surrounding plates encloses around or surrounds a periphery of the mounting plate 811, and are fixedly connected to the mounting plate 811, so as to define a holding space. The holding space is configured to be mounted with the rotating shaft assembly 90. The separating plates, such as the first separating plate 816 and the second separating plate 817, are arranged in the holding space, and are configured to be fixedly connected to the mounting plate 811 and at least one of the surrounding plates, so as to increase the strength of the housing body 81, such that the separating plates may be configured to fix and support the rotating shaft module 50, and may be also configured to separate the holding space.

A fixing portion 8111 is provided or arranged on the mounting plate 811 and configured to be fixedly connected to the first fixing portion 411 or the second fixing portion 412. For example, fixing means may include fixing by a bolt, a screw, or a gluing connection, or a snap connection, etc. A guide portion 8112 is arranged on the mounting plate 811 and configured to be mounted with the supporting member 82 and the elastic member 83. In an embodiment, the guide portion 8112 is a through hole, which is convenient to be inserted or engaged with the supporting member 82, such that the supporting member 82 may move along an extending direction of the through hole.

A middle portion of a side of each of the second surrounding plate 813 and the fourth surrounding plate 815 away from the mounting plate 811 is recessed towards a side of the corresponding one of the second surrounding plate 813 and the fourth surrounding plate 815 close to the mounting plate 811, so as to define an accommodating groove. The accommodating groove is configured to provide a room for other components such as the supporting member 82, the pallets 30, and the display module 900. A slider 8151 and a slider 8152 are arranged on a side of the fourth surrounding plate 815 facing towards the second surrounding plate 813, such that the slider 8151 is slidably arranged in the arc slide 371 of the first pallet 31, and the slider 8152 is slidably arranged in the arc slide 381 of the second pallet 32.

The separating plates, such as the first separating plate 816 and the second separating plate 817, are arranged opposite to the second surrounding plate 813, respectively. The first separating plate 816 is disposed between the second surrounding plate 813 and the second separating plate 817. A middle portion of a side of each of the first separating plate 816 and the second separating plate 817 away from the mounting plate 811 are recessed towards a side of the corresponding one of the first separating plate 816 and the second separating plate 817 close to the mounting plate 811, so as to define an accommodating groove. The accommodating groove is configured to provide a room for other components such as the supporting member 82, the pallets 30, and the display module 900. A slider 8171 and a slider 8172 are arranged on a side of the second separating plate 817 facing towards the fourth surrounding plate 815, such that the slider 8171 is slidably arranged in the arc slide 371 of the first pallet 31, and the slider 8172 is slidably arranged in the arc slide 381 of the second pallet 32. The slider 8171 and the slider 8172 on the second separating plate 817 and the slider 8151 and the slider 8152 on the fourth surrounding plate 815 cooperate to achieve a rotating connection between the first pallet 31 and the rotating shaft module 50, and a rotatable connection between the second pallet 32 and the rotating shaft module 50. In an embodiment, all of or a part of the separating plates may be omitted. In an embodiment, at most one of the second separating plate 817 and the fourth surrounding plate 815 may be omitted.

Understandably, the housing body 81 may be omitted and the supporting bracket 40 is configured to take place of the housing body 81 to mount and support the rotating shaft assembly 90. In an embodiment, the supporting bracket 40 may be omitted and the housing body 81 is configured to mount and support the rotating shaft assembly 90 and the pallets 30, thus the housing body 81 may also be referred to as the "supporting bracket". In an embodiment, the supporting bracket 40 and the housing body 81 are of an integrated structure, thus the housing body 81 may also be referred to as the "supporting bracket".

The supporting member 82 is arranged opposite to the mounting plate 811. The supporting member 82 is located in the accommodating groove defined in the second surrounding plate 813 and the accommodating grooves defined in the separating plates, and is abutted against the rotating shaft assembly 90. The supporting member 82 has a plate-shaped structure, and a mounting hole 821 is defined corresponding to the fixing portion 8111 of the mounting plate 811, such that through the mounting hole 821, the fixing portion 8111 of the mounting plate 811 may be mounted and fixed to, or removed from the first fixing portion 411 or the second fixing portion 412 of the supporting bracket 40.

A guide post 822 is arranged on a side of the supporting member 82 facing towards the mounting plate 811, extends towards the supporting member 811. The guide post 822 is arranged in the guide portion 8112 and moves relative to the guide portion 8112 in an extension direction of the guide post 822.

In an embodiment, abutting portions, such as a first abutting portion 823, a second abutting portion 824, and a third abutting portion 825, may be arranged on and protrude from a surface of the supporting member 82 facing towards the mounting plate 811 and extends towards the mounting plate 811. The abutting portions are configured to be abutted against the rotating shaft assembly 90, so as to facilitate an adjustment for a distance between the supporting member 82 and the mounting plate 811 when the rotating shaft assembly 90 is rotated, so as to provide the room for the display module 900, thereby allowing the electronic apparatus 000 to be better folded.

The resilient member 83 may be a spring or a resilient structure made of other elastic materials. The resilient member 83 has a function of resetting the supporting member 82, which reduce a possibility of the display module 900 being disengaged from the housing 100 and unable to be folded caused by the supporting member 82 disconnecting from the mounting plate 811. In an embodiment, the resilient member 83 is the spring, sleeved around a periphery of the guide post 822, and arranged in the guide portion 8112 together with the guide post 822. An end of the resilient member 83 is abutted against the supporting member 82, and the other end of the resilient member 83 is abutted against the mounting plate 811. In an embodiment, an end of the resilient member 83 is connected to the supporting member 82, and the other end of the resilient member 83 is connected to the mounting plate 811.

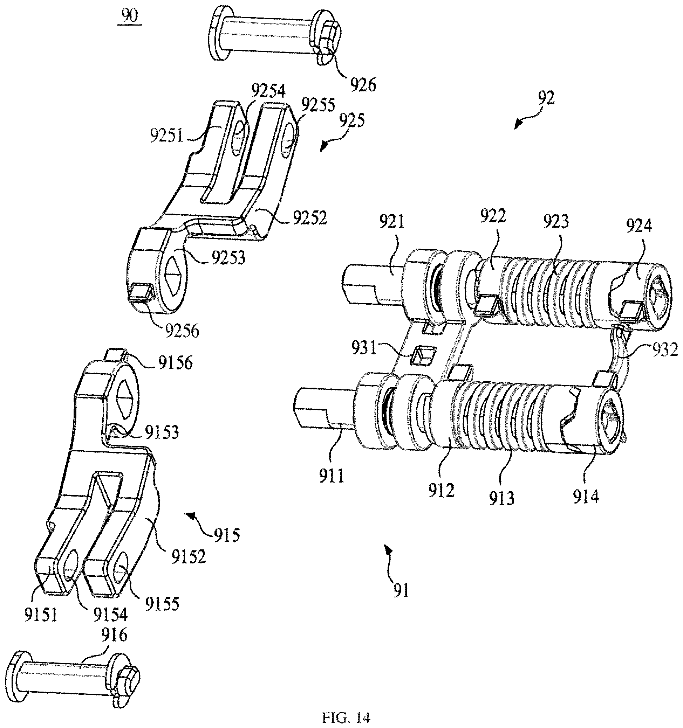

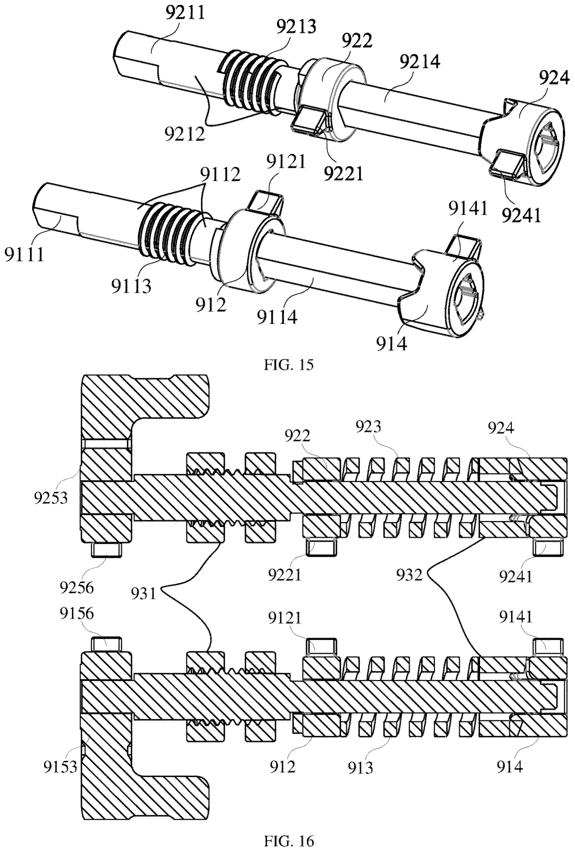

As shown in FIGS. 12, 14, 15, and 16, FIG. 14 is a structural schematic view of the rotating shaft assembly 90 according to an embodiment of the present disclosure, FIG. 15 is a structural schematic view of a part of a structure of the rotating shaft assembly 90 according to an embodiment of the present disclosure, and FIG. 16 is a cross-section schematic view of a part of the structure of the rotating shaft assembly 90 according to an embodiment of the present disclosure. The rotating shaft assembly 90 is fixed in a holding space. The rotating shaft assembly 90 may include a first rotating shaft assembly 91, a second rotating shaft assembly 92, and a connection assembly 93. The first rotating shaft assembly 91 and the second rotating shaft assembly 92 are fixed to the mounting housing 80. The first rotating shaft assembly 91 is configured to be connected to the connecting member 20 on the first housing 200. The second rotating shaft assembly 92 is configured to be connected to the connecting member 20 on the second housing 300. The connection assembly 93 is configured to be connected to the first rotating shaft assembly 91 and the second rotating shaft assembly 92, such that the first rotating shaft assembly 91 and the second rotating shaft assembly 92 may rotate synchronously.

Specifically, the first rotating shaft assembly 91 includes the rotating shaft 911, a first limiting slider 912, a spring 913, a second limiting slider 914, a rotating arm 915, and a connecting shaft 916. The rotating shaft 911 may sequentially penetrate through the second surrounding plate 813 and the separating plates (e.g., the first separating plate 816 and the second separating plate 817), and be mounted on the second surrounding plate 813 and the separating plates (e.g., the first separating plate 816 and the second separating plate 817). The rotating shaft 911 is movable in the axial direction of rotating shaft 911 and rotatable in a radial direction of the rotating shaft 911. The rotating shaft 911 may include an engaging portion 9111, a pivoting portion 9112, a threaded portion 9113, and a sliding portion 9114. The engaging portion 9111, the pivoting portion 9112, and the sliding portion 9114 are connected sequentially in the axial direction. The threaded portion 9113 may be located in a middle of the pivoting portion 9112 to separate or divide the pivoting portion 9112 into two portions. The engaging portion 9111 is configured to be engaged with the rotating arm 915, so as to allow the rotating arm 915 to slide on the engaging portion 9111 in the axial direction of the rotating shaft 911, and to rotate in the radial direction of the rotating shaft 911, such that the rotating shaft 911 may be driven to rotate. The pivoting portion 9112 is configured to be rotatably connected to the second surrounding plate 813 and the separating plate such as the first separating plate 816, such that the mounting housing 80 may support the rotating shaft 911. The threaded portion 9113 is configured to be thread to the connection assembly 93. The sliding portion 9114 is configured to be engaged with the first limiting slider 912, the second limiting slider 914, and the connection assembly 93, such that the first limiting slider 912, the second limiting slider 914, and the connection assembly 93 may slide along the axial direction of the rotating shaft 911, and the rotating shaft 911 rotates in the radial direction of the rotating shaft 911 to drive the first limiting slider 912, the second limiting slider 914, and the connection assembly 93 to rotate. The first limiting slider 912, the second limiting slider 914, and the connection assembly 93 are arranged between the first separating plate 816 and the second separating plate 817. The first limiting slider 912 is located at a side close to the first separating plate 816. The second limiting slider 914 is located at a side close to the second separating plate 817. A part of the connection assembly 93 is located between the first limiting slider 912 and the second limiting slider 914.

The spring 913 is sleeved on the sliding portion 9114, located between the first limiting slider 912 and the second limiting slider 914, and located between the first limiting slider 912 and the part of the connection assembly 93.

The first limiting slider 912 is sleeved on the sliding portion 9114. An abutting member 9121 is arranged on the first limiting slider 912, and extends towards the second rotating shaft assembly 92. The abutting member 9121 may be in shape of a block. The abutting member 9121 is configured to be abutted against the supporting member 82 such as the second abutting portion 824.

The second limiting slider 914 is sleeved on the sliding portion 9114. An abutting member 9141 is arranged on the second limiting slider 914, and extends towards the second rotating shaft assembly 92. The abutting member 9141 may be in shape of a block. The abutting member 9141 is configured to be abutted against the supporting member 82 such as the third abutting portion 825. A side of the second limiting slider 914 facing towards the first limiting slider 912 is recessed inwardly to define a limiting groove, so as to provide the room for the connection assembly 93, such that the rotating shaft 911 may rotate within a limited angle range. In this way, the electronic apparatus 000 may be flattened from a folded state, and a possibility of damaging the electronic apparatus 000 caused by folding backwards may be reduced.

The rotating arm 915 may include connecting arms (e.g., a first connecting arm 9151 and a second connecting arm 9152) and a rotating connection portion 9153. The number of the connecting arms may be one or more. For example, the number of the connecting arms may be two, i.e., the first connecting arm 9151 and the second connecting arm 9152, respectively. The first connecting arm 9151 and the second connecting arm 9152 are arranged in parallel and extend towards the connecting member 20, so as to be staggered with the first buffer arm 221 and the second buffer arm 222. An engaging hole 9154 is defined in the first connecting arm 9151 and configured to be engaged with the connecting shaft 916, such that the connecting shaft 916 passes through the engaging hole 9154 in an axial direction of the connecting shaft 916, and the first connecting arm 9151 may drive the connecting shaft 916 to rotate together in a radial direction of the connecting shaft 916. An engaging hole 9155 is defined in the second connecting arm 9152 and configured to be engaged with the connecting shaft 916, such that the connecting shaft 916 passes through the engaging hole 9155 in the axial direction of the connecting shaft 916, and the second connecting arm 9152 may drive the connecting shaft 916 to rotate together in the radial direction of the connecting shaft 916. The engaging hole 9154 and the engaging hole 9155 are arranged coaxially.

The rotating connection portion 9153 is engaged with the engaging portion 9111 of the rotating shaft 911, and arranged in the supporting bracket 40, such that the rotating arm 915 may slide on the engaging portion 9111 in the axial direction of the rotating shaft 911 and rotate in the radial direction of the rotating shaft 911 to drive the rotating shaft 911 to rotate. An abutting member 9156 in shape of substantially a block is arranged on the rotating connection portion 9153 and extends towards the second rotating shaft assembly 92. The abutting member 9156 is configured to be abutted against the supporting member 82 such as the first abutting portion 823.

The connecting shaft 916 is configured to be connected to the first buffer arm 221 and the second buffer arm 222 of the connecting member 20. The connecting shaft 916 may be arranged in the first strip through hole 2211 of the first buffer arm 221 and engaged with the first buffer arm 221, and arranged in the second strip through hole 2221 of the second buffer arm 222 and engaged with the second buffer arm 222, such that the connecting shaft 916 may slide in the first strip through hole 2211 and the second strip through hole 2221, respectively. In this way, the connecting shaft 916 may be driven to rotate when the first buffer arm 221 and the second buffer arm 222 rotate around an axis of the connecting shaft 916.

The second shaft assembly 92 has a similar structure to the first shaft assembly 91. For the structure, functions, and cooperative operations with other structures of the second shaft assembly 92, reference may be made to the first shaft assembly 91, which are not repeated herein. Only a structural composition of the second shaft assembly 92 is listed herein. As shown in FIGS. 12, 14, 15, and 16, the second rotating shaft assembly 92 may include the rotating shaft 921, a first limiting slider 922, a spring 923, a second limiting slider 924, a rotating arm 925, and a connecting shaft 926. A rotating shaft 921 may include an engaging portion 9211, a pivoting portion 9212, a threaded portion 9213, and a sliding portion 9214.

An abutting member 9221 is arranged on the first limiting slider 922, and extends towards the first rotating shaft assembly 91. The abutting member 9221 is configured to be abutted against the supporting member 82 such as the second abutting portion 824.

An abutting member 9241 is arranged on the second limiting slider 924, and extends towards the first rotating shaft assembly 91. The abutting member 9241 is configured to be abutted against the supporting member 82 such as the third abutting portion 825. A side of the second limiting slider 924 facing towards the first limiting slider 922 is recessed inwardly to define a limiting groove, so as to provide the room for the connection assembly 93, such that the rotating shaft 921 may rotate within a limited angle range. In this way, the electronic apparatus 000 may be flattened from the folded state, and the possibility of damaging the electronic apparatus 000 caused by folding backwards may be reduced.

The rotating arm 925 may include one or more connecting arms (e.g., a first connecting arm 9251 and a second connecting arm 9252) and a rotating connection portion 9253. The number of the connecting arms may be one or more. For example, the number of the connecting arms may be two, i.e., the first connecting arm 9251 and the second connecting arm 9252, respectively.

An engaging hole 9254 is defined in the first connecting arm 9251 and configured to be engaged with the connecting shaft 926, and an engaging hole 9255 is defined in the second connecting arm 9252 and configured to be engaged with the connecting shaft 926.

An abutting member 9256 is arranged on the rotating connection portion 9253 and extends towards the first rotating shaft assembly 91. The abutting member 9256 is configured to be abutted against the supporting member 82 such as the first abutting portion 823.

The connecting shaft 926 is configured to be connected to the first buffer arm 221 and the second buffer arm 222 of the connecting member 20. The connecting shaft 926 may be arranged in the first strip through hole 2211 of the first buffer arm 221 and engaged with the first buffer arm 221, and arranged in the second strip through hole 2221 of the second buffer arm 222 and engaged with the second buffer arm 222, such that the connecting shaft 926 may slide in the first strip through hole 2211 and the second strip through hole 2221, respectively. In this way, the connecting shaft 926 may be driven to rotate when the first buffer arm 221 and the second buffer arm 222 rotate around an axis of the connecting shaft 926.

The connection assembly 93 may include two connecting members, i.e., a first connecting member 931 and a second connecting member 932, respectively. The first connecting member 931 is located between the second surrounding plate 813 and the first separating plate 816, and threadedly connected to the threaded portion 9113 of the rotating shaft 911 and the threaded portion 9213 of the rotating shaft 921. The second connecting member 932 is located between the first separating plate 816 and the second separating plate 817, and rotatably connected to the sliding portion 9114 of the rotating shaft 911 and the sliding portion 9214 of the rotating shaft 921, respectively, such that the second connecting member 932 slides on the sliding portion 9114 in the axial direction of the rotating shaft 911 and rotate in the radial direction of the rotating shaft 911, and slides on the sliding portion 9214 in an axial direction of the rotating shaft 921 and rotate in an radial direction of the rotating shaft 921. A portion of the second connecting member 932 engaged with the rotating shaft 911 is located between the spring 913 and the second limiting slider 914. A portion of the second connecting member 932 engaged with the rotating shaft 921 is located between the spring 923 and the second limiting slider 924.

The portion of the second connecting member 932 engaged with the rotating shaft 911 protrudes towards the second limiting slider 914 to form a limiting protrusion, so as to cooperate with the limiting groove and achieve the rotating shaft 921 rotating within the limited angle range. In this way, the electronic apparatus 000 may be flattened from the folded state, and the possibility of damaging the electronic apparatus 000 caused by folding backwards may be reduced.

The portion of the second connecting member 932 engaged with the rotating shaft 921 protrudes towards the second limiting slider 924to form a limiting protrusion, so as to cooperate with the limiting groove and achieve the rotating shaft 921 rotating within the limited angle range. In this way, the electronic apparatus 000 may be flattened from the folded state, and the possibility of damaging the electronic apparatus 000 caused by folding backwards may be reduced.

It can be understood that, due to rotation of the rotating arm 915 and the rotating arm 925, the rotating shaft 911 and the rotating shaft 921 may rotate simultaneously, such that the rotating shaft 911 rotates threadedly with the first connecting member 931 and the rotating shaft 921 rotates threadedly with the first connecting member 931, which in turn allows the rotating shaft 911 and the rotating shaft 921 to move simultaneously in their axial directions. The rotating shaft 911 drives the first limiting slider 912 to move towards the second limiting slider 914, such that the spring 913 is compressed. Under the action of the spring 913, the rotating shaft 911 moves in an opposite direction, so as to keep the rotating shaft 911 stable. The rotating shaft 921 drives the first limiting slider 922 to move towards the second limiting slider 924, such that the spring 923 is compressed. Under the action of the spring 923, the rotating shaft 921 moves in an opposite direction, so as to keep the rotating shaft 921 stable and improve stability of the electronic apparatus 000. When the rotating shaft 911 and the rotating shaft 921 are rotated, the abutting member 9156, the abutting member 9256, the abutting member 9121, the abutting member 9221, the abutting member 9141, and the abutting member 9241 are rotated simultaneously, which in turn drives the supporting member 82 to move, thereby supporting the display module 900. Under the rotation of the rotating arm 915 and the rotating arm 925, a distance between the rotating arm 915 and the buffer arm may change, such that the connecting shaft 916 slides in the strip through holes such as the first strip through hole 2211 and the second strip through hole 2221. A distance between the rotating arm 925 and the buffer arm may change, such that the connecting shaft 926 slides in the strip through holes such as the first strip through hole 2211 and the second strip through hole 2221.

Understandably, the first limiting slider 922, the spring 923, the second limiting slider 924, and the second connecting member 932 may be assembled as a resilient assembly (also called as "elastic assembly") to keep the rotating shaft 921 stable. The first limiting slider 912, the spring 913, the second limiting slider 914, and the second connecting member 932 may be assembled as a resilient assembly (also called as "elastic assembly") to keep the rotating shaft 911 stable. Furthermore, the rotating shaft 911 and the rotating shaft 921 are disposed at two opposite sides of the supporting member 82, as shown in FIG. 11.

As shown in FIG. 1, the display module 900 may be a flexible display, and may be a variable and bendable display device made of a soft or flexible material. The display module 900 may be embedded in the first housing 200 and the second housing 300 and configured to display information. The display module 900 may be an integrated structure. Of course, the display module 900 may also be an assembly of two flexible displays, and the two flexible displays are embedded in the first housing 200 and the second housing 300, respectively That is, one of the two flexible displays is embedded in the first housing 200, and the other one of the two flexible displays is embedded in the second housing 300.

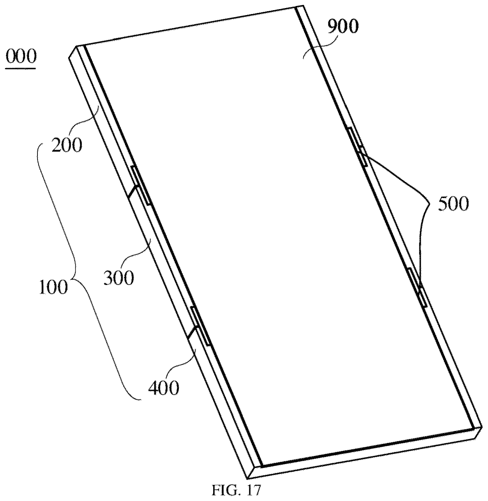

As shown in FIG. 17, and FIG. 17 is a structural schematic view of the electronic apparatus 000 according to another embodiment of the present disclosure. The electronic apparatus 000 may include the first housing 200, the second housing 300, a third housing 400, folding assemblies 500, and a display module 900. One of the folding assembly 500 is arranged between the first housing 200 and the second housing 300, such that the first housing 200 may be foldable relative to the second housing 300. Another of the folding assemblies 500 is arranged between the second housing 300 and the third housing 400, such that the second housing 300 may be foldable relative to the third housing 400. The display module 900 is arranged on the first housing 200, the second housing 300, the third housing 400, and the folding assemblies 500 and configured to display the information.

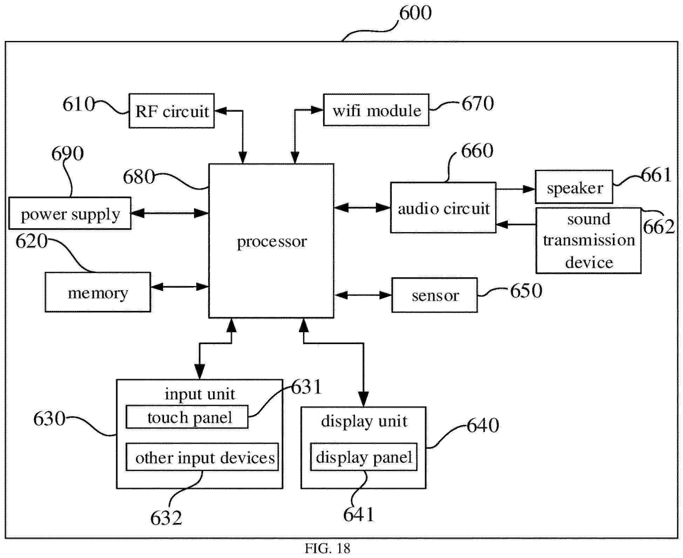

Further, some embodiments of the present disclosure also provide an electronic apparatus. As shown in FIG. 18, FIG. 18 is a structural schematic view of the electronic apparatus 600 according to an embodiment of the present disclosure. The electronic apparatus 600 may be a cell phone, a tablet computer, a laptop computer, and a wearable device, etc. This embodiment is illustrated with the cell phone as an example. A structure of the electronic apparatus 600 may include an RF circuit 610, a memory 620, an input unit 630, a display unit 640 (i.e., the display module 900 in the above embodiments), a sensor 650, an audio circuit 660, a wifi module 670, a processor 680, and a power supply 690, etc. The RF circuit 610, the memory 620, the input unit 630, the display unit 640, the sensor 650, the audio circuit 660, and the wifi module 670 are connected to the processor 680, respectively. The power supply 690 is configured to provide an electrical power for the entire electronic apparatus 600.

Specifically, the RF circuit 610 is configured to receive and transmit a signal. The memory 620 is configured to store data instruction information. The input unit 630 is configured to input the information, and may include a touch panel 631 and other input devices 632 such as an operation key. The display unit 640 may include a display panel 641, etc. The sensor 650 may include an infrared sensor, a laser sensor, etc., and be configured to detect a user proximity signal, a distance signal, etc. A speaker 661 and a sound transmission device 662 (or a microphone, or a receiver assembly) are connected to the processor 680 by means of the audio circuit 660, and are configured to receive and transmit a sound signal. The wifi module 670 is configured to receive and transmit a wifi signal. The processor 680 is configured to process data information of the electronic apparatus 600.

## Claims

1. A rotating shaft module (50), comprising:
a mounting housing (80);
two rotating shafts (911, 921), arranged opposite to each other and rotatably connected to the mounting housing (80), respectively; wherein each of the two rotating shafts (911, 921) is configured to slide relative to the mounting housing (80) in a sliding direction along an axis of each of the two rotating shafts;
an elastic assembly, sleeved on each of the two rotating shafts (911, 921), abutted against the mounting housing (80), and configured to apply a force to each of the two rotating shafts (911, 921) along a direction opposite to the sliding direction of the each of the two rotating shafts (911, 921), such that each of the two rotating shafts (911, 921) is kept stable;
whereby
the rotating shaft module (50) comprises:
a first connecting member (931), threaded to each of the two rotating shafts (911, 921); and
wherein the mounting housing (80) comprises:
a housing body (81), configured to be mounted with the two rotating shafts (911, 921);
a supporting member (82), arranged opposite to the housing body (81); wherein a side of the supporting member (82) facing towards the housing body (81) is abutted against the elastic assembly, the supporting member (82) is movably connected to the housing body (81) such that the supporting member (82) is movable in a direction away from or close to the housing body (81).

2. The rotating shaft module (50) according to claim 1, wherein the two rotating shafts (911, 921) are disposed at two opposite sides of the supporting member (82), and the mounting housing (80) comprises:
a resilient member (83), arranged between the housing body (81) and the supporting member (82); wherein an end of the resilient member (83) is abutted against the housing body (81), and the other end of the resilient member (83) is abutted against the supporting member (82).

3. The rotating shaft module (50) according to claim 2, wherein the housing body (81) comprises:
a mounting plate (811), wherein a guide portion (8112) is arranged on a side of the mounting plate (811) facing towards the supporting member (82) and configured to be movably connected to the supporting member (82);
surrounding plates (812, 813, 814, 815), disposed around the mounting plate (811) and defining a holding space, wherein a portion of each of the two rotating shafts (911, 921) is disposed in the holding space; and
a first separating plate (816) and a second separating plate (817), disposed in the holding space, wherein the surrounding plates (812, 813, 814, 815), the first separating plate (816), and the second separating plate (817) are rotatably connected to each of the two rotating shafts (911, 921), and the first separating plate (816) and the second separating plate (817) are configured to be abutted against the elastic assembly.

4. The rotating shaft module (50) according to claim 3, wherein a guide post (822) is arranged at a side of the supporting member (82) facing towards the mounting plate (811), extends towards the supporting member (82), and configured to be movably connected to the guide portion (8112).

5. The rotating shaft module (50) according to claim 4, wherein the resilient member (83) is a spring, sleeved on the guide post (822), and located in the guide portion (8112).

6. The rotating shaft module (50) according to any one of claims 3-5, wherein the elastic assembly comprises:
a first limiting slider (912, 922), arranged on each of the two rotating shafts (911, 921), and engaged with a corresponding one of the rotating shafts (911, 921), such that the first limiting slider (912, 922) is slidable along the axial direction;
a second limiting slider (914, 924), arranged on each of the two rotating shafts (911, 921), and engaged with a corresponding one of the rotating shafts (911, 921), such that the second limiting slider (914, 924) is slidable along the axial direction;
a second connecting member (932), rotatably connected to each of the two rotating shafts (911, 921) such that the second connecting member (932) is slidable in the axial direction; and
a spring (913), sleeved on each of the two rotating shafts (911, 921) and located between the first limiting slider (912, 922) and the second connecting member (932); wherein an end of the spring (913) is abutted against the first limiting slider (912, 922), and the other end of the spring (913) is abutted against second connecting member (932);
wherein both the first limiting slider (912, 922) and the second limiting slider (914, 924) are arranged between the first separating plate (816) and the second separating plate (817), the first limiting slider (912, 922) is abutted against the first separating plate (816), and the second limiting slider (914, 924) is abutted against the second separating plate (817).

7. The rotating shaft module (50) according to claim 6, wherein an abutting member (9121, 9221, 9141, 9241) is arranged on each of the first limiting slider (912, 922) and the second limiting slider (914, 924), and the abutting member (9121, 9221, 9141, 9241) is configured to be abutted against a side of the supporting member (82) facing towards the mounting plate (811) and adjust a distance between the mounting plate (811) and the supporting member (82).

8. The rotating shaft module (50) according to any one of claims 6-7, wherein each of the two rotating shafts (911, 921) comprises:
an engaging portion (9111, 9211);
a pivoting portion (9112, 9212), configured to be pivoted with the surrounding plates (812, 813, 814, 815) and the first separating plate (816);
a threaded portion (9113, 9213), configured to be threaded to the first connecting member (931); and
a sliding portion (9114, 9214), configured to be engaged with the first limiting slider (912, 922) and the second limiting slider (914, 924) such that the first limiting slider (912, 922) and the second limiting slider (914, 924) are slidable in the axial direction, and the sliding portion being configured to be rotatably connected to the second connecting member (932).

9. The rotating shaft module (50) according to claim 1, further comprising:
a rotating arm (915, 925), arranged on an end portion of each of the two rotating shafts (911, 921) and engaged with a corresponding one of the rotating shafts (911, 921), such that the rotating arm (915, 925) is slidable relative to the corresponding one of the rotating shafts (911, 921) along the axial direction.

10. The rotating shaft module (50) according to claim 9, wherein
an abutting member (9156, 9256) is arranged on the rotating arm (915, 925) and configured to be abutted against a side of the supporting member (82) facing towards the housing body (81) and adjust a distance between the housing body (81) and the supporting member (82); and
wherein the mounting housing (80) comprises a resilient member (83), arranged between the housing body (81) and the supporting member (82); wherein an end of the resilient member (83) is abutted against the housing body (81), and the other end of the resilient member (83) is abutted against the supporting member (82).

11. A folding assembly comprising:
a supporting bracket (40), defining a receiving space;
a first rotating shaft module (60), located in the receiving space, and arranged at an end of the supporting bracket (40); and
a second rotating shaft module (70), arranged symmetrically with the first rotating shaft module (60), located in the receiving space, and arranged at the other end of the supporting bracket (40);
wherein each of the first rotating shaft module (60) and the second rotating shaft module (70) is the rotating shaft module (50) according to any one of claims 1-9.

12. The folding assembly (500) according to claim 11, further comprising:
a first pallet (31), carried on both the first rotating shaft module (60) and the second rotating shaft module (70), and rotatably connected to the supporting bracket (40); and
a second pallet (32), carried on both the first rotating shaft module (60) and the second rotating shaft module (70), arranged symmetrically with the first pallet (31), and rotatably connected to the supporting bracket (40);
wherein the first pallet (31) and the second pallet (32) are configured to be in a same plane when the folding assembly (500) is flattened.

13. The folding assembly (500) according to claim 11, further comprising a plurality of connecting members (20), wherein
a first one of the connecting members (20) is configured to be rotatably connected to the first pallet (31) and rotatably connected to and slidable relative to one of the rotating arms (915, 925) of the first rotating shaft module (60);
a second one of the connecting members (20) is configured to be rotatably connected to the first pallet (31) and rotatably connected to and slidable relative to one of the rotating arms (915, 925) of the second rotating shaft module (70);
a third one of the connecting members (20) is configured to be rotatably connected to the second pallet (32) and rotatably connected to and slidable relative to the other one of the rotating arms (915, 925) of the first rotating shaft module (60); and
a fourth one of the connecting members (20) is configured to be rotatably connected to the second pallet (32) and rotatably connected to and slidable relative to the other one of the rotating arms (915, 925) of the second rotating shaft module (70).

14. An electronic apparatus (000) comprising:
a supporting bracket (40), defining a receiving space;
a rotating shaft module (50) according to any one of claims 1-8, located in the receiving space, arranged on the supporting bracket (40), and further comprising:
two rotating arms (915, 925), wherein one of the rotating arms (915, 925) is arranged on an end portion of one of the two rotating shafts (911, 921) and engaged with a corresponding one of the rotating shafts (911, 921), and the other of the rotating arms (915, 925) is arranged on an end portion of the other of the two rotating shafts (911, 921) and engaged with the other one of the rotating shafts (911,921), such that the rotating arms (915, 925) are slidable along the axial direction; a first pallet (31), mounted on the rotating shaft module (50), and rotatably connected to the mounting housing (80);
a second pallet (32), mounted on the rotating shaft module (50), arranged symmetrically with the first pallet (31), and rotatably connected to the mounting housing (80);
a first housing (200), rotatably connected to and slidable relative to one of the rotating arms (915, 925) of the rotating shaft module (50), and rotatably connected to the first pallet (31); and
a second housing (300), rotatably connected to and slidable relative to the other one of the rotating arms (915, 925) of the rotating shaft module (50), and rotatably connected to the second pallet (32);
wherein the first pallet (31) and the second pallet (32) are configured to be in a same plane when the rotating shaft module (50) is flattened.

15. The electronic apparatus (000) according to claim 14, further comprising a plurality of connecting members (20) arranged on each of the first housing (200) and the second housing (300); wherein the connecting members (20) on the first housing (200) are rotatably connected to the first pallet (31), and rotatably connected to and slidable relative to the one of the rotating arms (915, 925) of the rotating shaft module (50); and
the connecting members (20) on the second housing (300) are rotatably connected to the second pallet (32) and rotatably connected to and slidable relative to the other one of the rotating arms (915, 925) of the rotating shaft module (50);
wherein the electronic apparatus (000) further comprises:
a display module (900), embedded in the first housing (200) and the second housing (300); wherein the first pallet (31) and the second pallet (32) are configured to carry the display module (900).

## Patentansprüche

1. Drehwellenmodul (50), umfassend:
ein Montagegehäuse (80);
zwei Drehwellen (911, 921), die einander gegenüberliegend angeordnet und drehbar jeweils mit dem Montagegehäuse (80) verbunden sind; wobei jede der zwei Drehwellen (911, 921) so ausgebildet ist, dass sie relativ zu dem Montagegehäuse (80) in einer Gleitrichtung entlang einer Achse jeder der zwei Drehwellen gleitet;
eine elastische Anordnung, die auf jede der zwei Drehwellen (911, 921) aufgeschoben ist, an dem Montagegehäuse (80) anliegt und so ausgebildet ist, dass auf jede der zwei Drehwellen (911, 921) entlang einer zu der Gleitrichtung jeder der zwei Drehwellen (911, 921) entgegengesetzten Richtung eine Kraft ausgeübt wird, sodass jede der zwei Drehwellen (911, 921) in einer stabilen Lage gehalten wird;
wobei das Drehwellenmodul (50) Folgendes umfasst:
ein erstes Verbindungselement (931), das mit jeder der zwei Drehwellen (911, 921) verschraubt ist; und
wobei das Montagegehäuse (80) Folgendes umfasst:
einen Gehäusekörper (81), der so ausgebildet ist, dass er mit den zwei Drehwellen (911, 921) montiert ist;
ein Tragelement (82), das gegenüber dem Gehäusekörper (81) angeordnet ist; wobei eine dem Gehäusekörper (81) zugewandte Seite des Tragelements (82) an der elastischen Anordnung anliegt und das Tragelement (82) beweglich mit dem Gehäusekörper (81) verbunden ist, sodass das Tragelement (82) in einer Richtung weg von oder nahe zu dem Gehäusekörper (81) beweglich ist.

2. Drehwellenmodul (50) nach Anspruch 1, wobei die zwei Drehwellen (911, 921) an zwei gegenüberliegenden Seiten des Tragelements (82) positioniert sind und das Montagegehäuse (80) Folgendes umfasst:
ein dehnbares Element (83), das zwischen dem Gehäusekörper (81) und dem Tragelement (82) angeordnet ist; wobei ein Ende des dehnbaren Elements (83) an dem Gehäusekörper (81) anliegt und das andere Ende des dehnbaren Elements (83) an dem Tragelement (82) anliegt.

3. Drehwellenmodul (50) nach Anspruch 2, wobei der Gehäusekörper (81) Folgendes umfasst:
eine Montageplatte (811), wobei ein Führungsabschnitt (8112) auf einer dem Tragelement (82) zugewandten Seite der Montageplatte (811) angeordnet und so ausgebildet ist, dass er beweglich mit dem Tragelement (82) verbunden ist;
umgebende Platten (812, 813, 814, 815), die um die Montageplatte (811) herum positioniert sind und einen Halteraum definieren, wobei ein Abschnitt jeder der zwei Drehwellen (911, 921) in dem Halteraum positioniert ist; und
eine erste Trennplatte (816) und eine zweite Trennplatte (817), die in dem Halteraum positioniert sind, wobei die umgebenden Platten (812, 813, 814, 815), die erste Trennplatte (816) und die zweite Trennplatte (817) drehbar mit jeder der zwei Drehwellen (911, 921) verbunden sind und die erste Trennplatte (816) und die zweite Trennplatte (817) so ausgebildet sind, dass sie an der elastischen Anordnung anliegen.

4. Drehwellenmodul (50) nach Anspruch 3, wobei ein Führungsstift (822) an einer der Montageplatte (811) zugewandten Seite des Tragelements (82) angeordnet ist, sich zu dem Tragelement (82) hin erstreckt und so ausgebildet ist, dass er beweglich mit dem Führungsabschnitt (8112) verbunden ist.

5. Drehwellenmodul (50) nach Anspruch 4, wobei das dehnbare Element (83) eine auf den Führungsstift (822) aufgeschobene Feder ist und sich in dem Führungsabschnitt (8112) befindet.

6. Drehwellenmodul (50) nach einem der Ansprüche 3-5, wobei die elastische Anordnung Folgendes umfasst:
ein erstes begrenzendes Gleitstück (912, 922), das auf jeder der zwei Drehwellen (911, 921) angeordnet ist und mit einer entsprechenden der Drehwellen (911, 921) in Eingriff steht, sodass das erste begrenzende Gleitstück (912, 922) zum Gleiten entlang der Achsenrichtung fähig ist;
ein zweites begrenzendes Gleitstück (914, 924), das auf jeder der zwei Drehwellen (911, 921) angeordnet ist und mit einer entsprechenden der Drehwellen (911, 921) in Eingriff steht, sodass das zweite begrenzende Gleitstück (914, 924) zum Gleiten entlang der Achsenrichtung fähig ist;
ein zweites Verbindungselement (932), das drehbar mit jeder der zwei Drehwellen (911, 921) verbunden ist, sodass das zweite Verbindungselement (932) zum Gleiten in der Achsenrichtung fähig ist; und
eine Feder (913), die auf jede der zwei Drehwellen (911, 921) aufgeschoben ist und sich zwischen dem ersten begrenzenden Gleitstück (912, 922) und dem zweiten Verbindungselement (932) befindet; wobei ein Ende der Feder (913) an dem ersten begrenzenden Gleitstück (912, 922) anliegt und das andere Ende der Feder (913) an dem zweiten Verbindungselement (932) anliegt;
wobei sowohl das erste begrenzende Gleitstück (912, 922) als auch das zweite begrenzende Gleitstück (914, 924) zwischen der ersten Trennplatte (816) und der zweiten Trennplatte (817) angeordnet sind, das erste begrenzende Gleitstück (912, 922) an der ersten Trennplatte (816) anliegt und das zweite begrenzende Gleitstück (914, 924) an der zweiten Trennplatte (817) anliegt.

7. Drehwellenmodul (50) nach Anspruch 6, wobei ein anliegendes Element (9121, 9221, 9141, 9241) auf jedem von dem ersten begrenzenden Gleitstück (912, 922) und dem zweiten begrenzenden Gleitstück (914, 924) angeordnet ist und das anliegende Element (9121, 9221, 9141, 9241) so ausgebildet ist, dass es an einer der Montageplatte (811) zugewandten Seite des Tragelements (82) anliegt und einen Abstand zwischen der Montageplatte (811) und dem Tragelement (82) anpasst.

8. Drehwellenmodul (50) nach einem der Ansprüche 6-7, wobei jede der zwei Drehwellen (911, 921) Folgendes umfasst:
einen Eingriffsabschnitt (9111, 9211);
einen Schwenkabschnitt (9112, 9212), der so ausgebildet ist, dass er mit den umgebenden Platten (812, 813, 814, 815) und der ersten Trennplatte (816) geschwenkt wird;
einen Gewindeabschnitt (9113, 9213), der so ausgebildet ist, dass er mit dem ersten Verbindungselement (931) verschraubt wird; und
einen Gleitabschnitt (9114, 9214), der so ausgebildet ist, dass er mit dem ersten begrenzenden Gleitstück (912, 922) und dem zweiten begrenzenden Gleitstück (914, 924) in Eingriff gebracht wird, sodass das erste begrenzende Gleitstück (912, 922) und das zweite begrenzende Gleitstück (914, 924) zum Gleiten in der Achsenrichtung fähig sind, und wobei der Gleitabschnitt so ausgebildet ist, dass er drehbar mit dem zweiten Verbindungselement (932) verbunden wird.

9. Drehwellenmodul (50) nach Anspruch 1, ferner umfassend:
einen Dreharm (915, 925), der auf einem Endabschnitt jeder der zwei Drehwellen (911, 921) angeordnet ist und mit einer entsprechenden der Drehwellen (911, 921) in Eingriff steht, sodass der Dreharm (915, 925) zum Gleiten relativ zu der entsprechenden der Drehwellen (911, 921) entlang der Achsenrichtung fähig ist.

10. Drehwellenmodul (50) nach Anspruch 9, wobei
ein anliegendes Element (9156, 9256) auf dem Dreharm (915, 925) angeordnet und so ausgebildet ist, dass es an einer dem Gehäusekörper (81) zugewandten Seite des Tragelements (82) anliegt und einen Abstand zwischen dem Gehäusekörper (81) und dem Tragelement (82) anpasst; und
wobei das Montagegehäuse (80) ein dehnbares Element (83), das zwischen dem Gehäusekörper (81) und dem Tragelement (82) angeordnet ist, umfasst; wobei ein Ende des dehnbaren Elements (83) an dem Gehäusekörper (81) anliegt und das andere Ende des dehnbaren Elements (83) an dem Tragelement (82) anliegt.

11. Faltanordnung, umfassend:
einen Auflageträger (40), der einen Aufnahmeraum definiert;
ein erstes Drehwellenmodul (60), das sich in dem Aufnahmeraum befindet und an einem Ende des Auflageträgers (40) angeordnet ist; und
ein zweites Drehwellenmodul (70), das symmetrisch zu dem ersten Drehwellenmodul (60) angeordnet ist, sich in dem Aufnahmeraum befindet und an dem anderen Ende des Auflageträgers (40) angeordnet ist;
wobei es sich sowohl bei dem ersten Drehwellenmodul (60) als auch bei dem zweiten Drehwellenmodul (70) um das Drehwellenmodul (50) nach einem der Ansprüche 1-9 handelt.

12. Faltanordnung (500) nach Anspruch 11, ferner umfassend:
eine erste Palette (31), die auf sowohl dem ersten Drehwellenmodul (60) als auch dem zweiten Drehwellenmodul (70) getragen wird und drehbar mit dem Auflageträger (40) verbunden ist; und
eine zweite Palette (32), die auf sowohl dem ersten Drehwellenmodul (60) als auch dem zweiten Drehwellenmodul (70) getragen wird, symmetrisch zu der ersten Palette (31) angeordnet ist und drehbar mit dem Auflageträger (40) verbunden ist;
wobei die erste Palette (31) und die zweite Palette (32) so ausgebildet sind, dass sie in einer selben Ebene sind, wenn die Faltanordnung (500) flach zusammengeklappt ist.

13. Faltanordnung (500) nach Anspruch 11, ferner umfassend eine Vielzahl von Verbindungselementen (20), wobei
ein erstes der Verbindungselemente (20) so ausgebildet ist, dass es drehbar mit der ersten Palette (31) verbunden und drehbar mit einem der Dreharme (915, 925) des ersten Drehwellenmoduls (60) verbunden und zum Gleiten relativ zu diesem einen Dreharm fähig ist;
ein zweites der Verbindungselemente (20) so ausgebildet ist, dass es drehbar mit der ersten Palette (31) verbunden und drehbar mit einem der Dreharme (915, 925) des zweiten Drehwellenmoduls (70) verbunden und zum Gleiten relativ zu diesem einen Dreharm fähig ist;
ein drittes der Verbindungselemente (20) so ausgebildet ist, dass es drehbar mit der zweiten Palette (32) verbunden und drehbar mit dem anderen der Dreharme (915, 925) des ersten Drehwellenmoduls (60) verbunden und zum Gleiten relativ zu diesem anderen Dreharm fähig ist; und
ein viertes der Verbindungselemente (20) so ausgebildet ist, dass es drehbar mit der zweiten Palette (32) verbunden und drehbar mit dem anderen der Dreharme (915, 925) des zweiten Drehwellenmoduls (70) verbunden und zum Gleiten relativ zu diesem anderen Dreharm fähig ist.

14. Elektronische Vorrichtung (000), umfassend:
einen Auflageträger (40), der einen Aufnahmeraum definiert;
ein Drehwellenmodul (50) nach einem der Ansprüche 1-8, das sich in dem Aufnahmeraum befindet, angeordnet auf dem Auflageträger (40), und ferner umfassend:
zwei Dreharme (915, 925), wobei einer der Dreharme (915, 925) auf einem Endabschnitt einer der zwei Drehwellen (911, 921) angeordnet ist und mit einer entsprechenden der Drehwellen (911, 921) in Eingriff steht und der andere der Dreharme (915, 925) auf einem Endabschnitt der anderen der zwei Drehwellen (911, 921) angeordnet ist und mit der anderen der Drehwellen (911, 921) in Eingriff steht, sodass die Dreharme (915, 925) zum Gleiten entlang der Achsenrichtung fähig sind; eine erste Palette (31), die auf dem Drehwellenmodul (50) montiert und drehbar mit dem Montagegehäuse (80) verbunden ist;
eine zweite Palette (32), die auf dem Drehwellenmodul (50) montiert, symmetrisch zu der ersten Palette (31) angeordnet und drehbar mit dem Montagegehäuse (80) verbunden ist;
ein erstes Gehäuse (200), das drehbar mit einem der Dreharme (915, 925) des Drehwellenmoduls (50) verbunden und zum Gleiten relativ zu diesem einen Dreharm fähig und drehbar mit der ersten Palette (31) verbunden ist; und
ein zweites Gehäuse (300), das drehbar mit dem anderen der Dreharme (915, 925) des Drehwellenmoduls (50) verbunden und zum Gleiten relativ zu diesem anderen Dreharm fähig und drehbar mit der zweiten Palette (32) verbunden ist;
wobei die erste Palette (31) und die zweite Palette (32) so ausgebildet sind, dass sie in einer selben Ebene sind, wenn das Drehwellenmodul (50) flach zusammengeklappt ist.

15. Elektronische Vorrichtung (000) nach Anspruch 14, ferner umfassend eine Vielzahl von auf sowohl dem ersten Gehäuse (200) als auch dem zweiten Gehäuse (300) angeordneten Verbindungselementen (20); wobei die Verbindungselemente (20) auf dem ersten Gehäuse (200) drehbar mit der ersten Palette (31) verbunden sind und drehbar mit dem einen der Dreharme (915, 925) des Drehwellenmoduls (50) verbunden und zum Gleiten relativ zu diesem einen Dreharm fähig sind; und
die Verbindungselemente (20) auf dem zweiten Gehäuse (300) drehbar mit der zweiten Palette (32) verbunden sind und drehbar mit dem anderen der Dreharme (915, 925) des Drehwellenmoduls (50) verbunden und zum Gleiten relativ zu diesem anderen Dreharm fähig sind;
wobei die elektronische Vorrichtung (000) ferner Folgendes umfasst:
ein in dem ersten Gehäuse (200) und dem zweiten Gehäuse (300) eingebettetes Anzeigemodul (900); wobei die erste Palette (31) und die zweite Palette (32) so ausgebildet sind, dass sie das Anzeigemodul (900) tragen.

## Revendications

1. Module d'arbre rotatif (50), comprenant :
un boîtier de montage (80) ;
deux arbres rotatifs (911, 921), disposés à l'opposé l'un de l'autre et reliés de manière rotative au boîtier de montage (80), respectivement ; dans lequel chacun des deux arbres rotatifs (911, 921) est conçu pour coulisser par rapport au boîtier de montage (80) dans une direction de coulissement le long d'un axe de chacun des deux arbres rotatifs ;
un ensemble élastique, emmanché sur chacun des deux arbres rotatifs (911, 921), venant en butée contre le boîtier de montage (80), et conçu pour appliquer une force sur chacun des deux arbres rotatifs (911, 921) le long d'une direction opposée à la direction de coulissement de chacun des deux arbres rotatifs (911, 921), de telle sorte que chacun des deux arbres rotatifs (911, 921) est maintenu stable ;
dans lequel
le module d'arbre rotatif (50) comprend :
un premier organe de liaison (931), fileté sur chacun des deux arbres rotatifs (911, 921) ; et
dans lequel le boîtier de montage (80) comprend :
un corps de boîtier (81), conçu pour être monté avec les deux arbres rotatifs (911, 921) ;
un organe de support (82), disposé à l'opposé du corps de boîtier (81) ; dans lequel un côté de l'organe de support (82) faisant face au corps de boîtier (81) vient en butée contre l'ensemble élastique, l'organe de support (82) est relié mobile au corps de boîtier (81) de telle sorte que l'organe de support (82) est mobile en direction de ou à distance du corps de support (81).

2. Module d'arbre rotatif (50) selon la revendication 1, dans lequel les deux arbres rotatifs (911, 921) sont disposés sur deux côtés opposés de l'organe de support (82), et le boîtier de montage (80) comprend :
un organe résilient (83), disposé entre le corps de boîtier (81) et l'organe de support (82) ; dans lequel une extrémité de l'organe résilient (83) vient en butée contre le corps de boîtier (81), et l'autre extrémité de l'organe résilient (83) vient en butée contre l'organe de support (82).

3. Module d'arbre rotatif (50) selon la revendication 2, dans lequel le corps de boîtier (81) comprend :
une plaque de montage (811), dans lequel une partie de guidage (8112) est disposée sur un côté de la plaque de montage (811) faisant face à l'organe de support (82) et conçue pour être reliée mobile à l'organe de support (82) ;
des plaques d'entourage (812, 813, 814, 815) disposées autour de la plaque de montage (811) et définissant un espace de retenue, dans lequel une partie de chacun des deux arbres rotatifs (911, 921) est disposée dans l'espace de retenue ; et
une première plaque de séparation (816) et une seconde plaque de séparation (817), disposées dans l'espace de retenue, dans lequel les plaques d'entourage (812, 813, 814, 815), la première plaque de séparation (816), et la seconde plaque de séparation (817) sont reliées en rotation à chacun des deux arbres rotatifs (911, 921), et la première plaque de séparation (816) et la seconde plaque de séparation (817) sont conçues pour venir en butée contre l'ensemble élastique.

4. Module d'arbre rotatif (50) selon la revendication 3, dans lequel un montant de guidage (822) est disposé sur un côté de l'organe de support (82) faisant face à la plaque de montage (811), s'étend vers l'organe de support (82), et est conçu pour être relié mobile à la partie de guidage (8112).

5. Module d'arbre rotatif (50) selon la revendication 4, dans lequel l'organe résilient (83) est un ressort, emmanché sur le montant de guidage (822), et situé dans la partie de guidage (8112).

6. Module d'arbre rotatif (50) selon l'une quelconque des revendications 3 à 5, dans lequel l'ensemble élastique comprend :
une première glissière de limitation (912, 922), disposée sur chacun des deux arbres rotatifs (911, 921), et en prise avec l'un correspondant des arbres rotatifs (911, 921), de telle sorte que la première glissière de limitation (912, 922) peut coulisser dans la direction axiale ;
une seconde glissière de limitation (914, 924) disposée sur chacun des deux arbres rotatifs (911, 921), et en prise avec l'un correspondant des arbres rotatifs (911, 921), de telle sorte que la seconde glissière de limitation (914, 924) peut coulisser dans la direction axiale ;
un second organe de liaison (932), relié en rotation à chacun des deux arbres rotatifs (911, 921) de telle sorte que le second organe de liaison (932) peut coulisser dans la direction axiale ; et
un ressort (913), emmanché sur chacun des deux arbres rotatifs (911, 921) et situé entre la première glissière de limitation (912, 922) et le second organe de liaison (932) ; dans lequel une extrémité du ressort (913) vient en butée contre la première glissière de limitation (912, 922), et l'autre extrémité du ressort (913) vient en butée contre le second organe de liaison (932) ;
dans lequel la première glissière de limitation (912, 922) et la seconde glissière de limitation (914, 924) sont toutes deux disposées entre la première plaque de séparation (816) et la seconde plaque de séparation (817), la première glissière coulissante (912, 922) vient en butée contre la première plaque de séparation (816), et la seconde glissière coulissante (914, 924) vient en butée contre la seconde plaque de séparation (817) .

7. Module d'arbre rotatif (50) selon la revendication 6, dans lequel un organe de butée (9121, 9221, 9141, 9241) est disposé sur chacune de la première glissière de limitation (912, 922) et de la seconde glissière de limitation (914, 924), et l'organe de butée (9121, 9221, 9141, 9241) est conçu pour venir en butée contre un côté de l'organe de support (82) faisant face à la plaque de montage (811) et régler une distance entre la plaque de montage (811) et l'organe de support (82).

8. Module d'arbre rotatif (50) selon l'une quelconque des revendications 6 et 7, dans lequel chacun des deux arbres rotatifs (911, 921) comprend :
une partie de prise (9111, 9211) ;
une partie pivotante (9112, 9212), conçue pour pivoter avec les plaques d'entourage (812, 813, 814, 815) et la première plaque de séparation (816) ;
une partie filetée (9113, 9213), conçue pour être filetée sur le premier organe de liaison (931) ; et
une partie coulissante (9114, 9214), conçue pour venir en prise avec la première glissière de limitation (912, 922) et la seconde glissière de limitation (914, 924) de telle sorte que la première glissière de limitation (912, 922) et la seconde glissière de limitation (914, 924) peuvent coulisser dans la direction axiale, et la partie coulissante étant conçue pour être reliée en rotation au second organe de liaison (932).

9. Module d'arbre rotatif (50) selon la revendication 1, comprenant en outre :
un bras rotatif (915, 925), disposé sur une partie d'extrémité de chacun des deux arbres rotatifs (911, 921) et en prise avec l'un correspondant des arbres rotatifs (911, 921), de telle sorte que le bras rotatif (915, 925) peut coulisser par rapport à l'arbre rotatif (911, 921) correspondant dans la direction axiale.

10. Module d'arbre rotatif (50) selon la revendication 9, dans lequel
un organe de butée (9156, 9256) est disposé sur le bras rotatif (915, 925) et conçu pour venir en butée contre un côté de l'organe de support (82) faisant face au corps de boîtier (81) et régler une distance entre le corps de boîtier (81) et l'organe de support (82) ; et dans lequel le boîtier de montage (80) comprend un organe résilient (83), disposé entre le corps de boîtier (81) et l'organe de support (82) ; dans lequel une extrémité de l'organe résilient (83) vient en butée contre le corps de boîtier (81), et l'autre extrémité de l'organe résilient (83) vient en butée contre l'organe de support (82).

11. Ensemble pliable comprenant :
une équerre de support (40), définissant un espace de réception ;
un premier module d'arbre rotatif (60), situé dans l'espace de réception, et disposé à une extrémité de l'équerre de support (40) ; et
un second module d'arbre rotatif (70), disposé symétriquement au premier module d'arbre rotatif (60), situé dans l'espace de réception, et disposé à l'autre extrémité de l'équerre de support (40) ;
dans lequel chacun du premier module d'arbre rotatif (60) et du second module d'arbre rotatif (70) est le module d'arbre rotatif (50) selon l'une quelconque des revendications 1 à 9.

12. Ensemble pliable (500) selon la revendication 11, comprenant en outre :
une première plaque (31), portée à la fois sur le premier module d'arbre rotatif (60) et le second module d'arbre rotatif (70), et reliée en rotation à l'équerre de support (40) ; et
une seconde plaque (32), portée à la fois sur le premier module d'arbre rotatif (60) et le second module d'arbre rotatif (70), disposée symétriquement à la première plaque (31), et reliée en rotation à l'équerre de support (40) ;
dans lequel la première plaque (31) et la seconde plaque (32) sont conçues pour se trouver dans un même plan lorsque l'ensemble pliable (500) est aplati.

13. Ensemble pliable (500) selon la revendication 11, comprenant en outre une pluralité d'organes de liaison (20), dans lequel
un premier des organes de liaison (20) est conçu pour être relié en rotation à la première plaque (31) et relié en rotation et pouvant coulisser par rapport à l'un des bras rotatifs (915, 925) du premier module d'arbre de rotation (60) ;
un deuxième des organes de liaison (20) est conçu pour être relié en rotation à la première plaque (31) et relié en rotation et pouvant coulisser par rapport à l'un des bras rotatifs (915, 925) du second module d'arbre de rotation (70) ;
un troisième des organes de liaison (20) est conçu pour être relié en rotation à la seconde plaque (32) et relié en rotation et pouvant coulisser par rapport à l'autre des bras rotatifs (915, 925) du premier module d'arbre de rotation (60) ; et
un quatrième des organes de liaison (20) est conçu pour être relié en rotation à la seconde plaque (32) et relié en rotation et pouvant coulisser par rapport à l'autre des bras rotatifs (915, 925) du second module d'arbre de rotation (70).

14. Appareil électronique (000) comprenant :
une équerre de support (40), définissant un espace de réception ;
un module d'arbre rotatif (50) selon l'une quelconque des revendications 1 à 8, situé dans l'espace de réception, disposé sur l'équerre de support (40) et comprenant en outre :
deux bras rotatifs (915, 925), dans lequel l'un des bras rotatifs (915, 925) est disposé sur une partie d'extrémité de l'un des deux arbres rotatifs (911, 921) et en prise avec l'un correspondant des arbres rotatifs (911, 921), et l'autre des bras rotatifs (915, 925) est disposé sur une partie d'extrémité de l'autre des deux arbres rotatifs (911, 921) et en prise avec l'autre des arbres rotatifs (911, 921), de telle sorte que les bras rotatifs (915, 925) peuvent coulisser dans la direction axiale ; une première plaque (31), montée sur le module d'arbre rotatif (50), et reliée en rotation au boîtier de montage (80) ;
une seconde plaque (32), montée sur le module d'arbre rotatif (50), disposée symétriquement à la première plaque (31), et reliée en rotation au boîtier de montage (80) ;
un premier boîtier (200), relié en rotation à et pouvant coulisser par rapport à l'un des bras rotatifs (915, 925) du module d'arbre rotatif (50), et relié en rotation à la première plaque (31) ; et
un second boîtier (300) relié en rotation à et pouvant coulisser par rapport à l'autre des bras rotatifs (915, 925) du module d'arbre rotatif (50), et relié en rotation à la seconde plaque (32) ;
dans lequel la première plaque (31) et la seconde plaque (32) sont conçues pour se trouver dans un même plan lorsque le module d'arbre rotatif (50) est aplati.

15. Appareil électronique (000) selon la revendication 14, comprenant en outre une pluralité d'organes de liaison (20) disposés sur chacun du premier boîtier (200) et du second boîtier (300) ; dans lequel les organes de liaison (20) sur le premier boîtier (200) sont reliés en rotation à la première plaque (31), et reliés en rotation et pouvant coulisser par rapport à l'un des bras rotatifs (915, 925) du module d'arbre rotatif (50) ; et
les organes de liaison (20) sur le second boîtier (300) sont reliés en rotation à la seconde plaque (32) et reliés en rotation et pouvant coulisser par rapport à l'autre des bras rotatifs (915, 925) du module d'arbre rotatif (50) ;
dans lequel l'appareil électronique (000) comprend en outre :
un module d'affichage (900), intégré dans le premier boîtier (200) et le second boîtier (300) ; dans lequel la première plaque (31) et la seconde plaque (32) sont conçues pour porter le module d'affichage (900).
